# EUROPEAN PATENT APPLICATION

(11) **EP 3 174 085 A1**
(43) Date of publication of application: **31.05.2017**
(21) Application number: 15196917.7
(22) Date of filing: 30.11.2015
(51) Int. Cl.: H01J 37/05, H01J 37/28

(54) **FILTER ASSEMBLY FOR DISCRIMINATING SECONDARY AND BACKSCATTERED ELECTRONS IN A NON-TRANSMISSION CHARGED PARTICLE MICROSCOPE**

(71) Applicant: FEI Company, Hillsboro, OR 97124-5793 (US)
(72) Inventor: Vasina, Radovan, 634 00 Brno (CZ)
(74) Representative: Bakker, Hendrik

(57) **Abstract**

A method of examining a specimen in a non-transmission Charged Particle Microscope, comprising the following steps:
- Providing a specimen on a specimen holder;
- Directing an irradiating beam of charged particles from a source through an illuminator so as to irradiate the specimen;
- Causing relative motion of the beam relative to the specimen, so as to trace out a scan path;
- Using a detector to detect a flux of electrons emanating from the specimen in response to said irradiation,

wherein a filter assembly is provided between said specimen and illuminator, and is used to manipulate said flux of electrons so as to:
- Preferentially pass a first category of electrons to the detector;
- Selectively impede a second category of electrons from being registered by the detector, whereby:
- Electrons in said first category have a higher energy than electrons in said second category;
- The filter assembly causes a deflection of electrons in said flux, which deflection is different for said first and second categories.

## Description

The invention relates to a method of examining a specimen in a non-transmission Charged Particle Microscope, comprising the following steps:
- Providing a specimen on a specimen holder;
- Directing an irradiating beam of charged particles from a source through an illuminator so as to irradiate the specimen;
- Causing relative motion of the beam relative to the specimen, so as to trace out a scan path;
- Using a detector to detect a flux of electrons emanating from the specimen in response to said irradiation.

The invention also relates to a non-transmission Charged Particle Microscope in which such a method can be enacted.

Charged particle microscopy is a well-known and increasingly important technique for imaging microscopic objects, particularly in the form of electron microscopy. Historically, the basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called "dual-beam" tools (e.g. a FIB-SEM), which additionally employ a "machining" Focused Ion Beam (FIB), allowing supportive activities such as ion-beam milling or Ion-Beam-Induced Deposition (IBID), for example. More specifically:
- In a SEM, irradiation of a specimen by a scanning electron beam precipitates emanation of "auxiliary" radiation from the specimen, in the form of secondary electrons, backscattered electrons, X-rays and photoluminescence (infrared, visible and/or ultraviolet photons), for example; one or more components of this emanating radiation is/are then detected and used for image accumulation purposes.
- In a TEM, the electron beam used to irradiate the specimen is chosen to be of a high-enough energy to penetrate the specimen (which, to this end, will generally be thinner than in the case of a SEM specimen); the transmitted electrons emanating from the specimen can then be used to create an image. When such a TEM is operated in scanning mode (thus becoming a STEM), the image in question will be accumulated during a scanning motion of the irradiating electron beam.

More information on some of the topics elucidated here can, for example, be gleaned from the following Wikipedia links:
http://en.wikipedia.ora/wiki/Electron microscope
http://en.wikipedia.org/wiki/Scanning electron microscope
http://en.wikipedia.org/wiki/Transmission electron microscopy
http://en.wikipedia.org/wiki/Scanning transmission electron microscopy

As an alternative to the use of electrons as irradiating beam, charged particle microscopy can also be performed using other species of charged particle. In this respect, the phrase "charged particle" should be broadly interpreted as encompassing electrons, positive ions (e.g. Ga or He ions), negative ions, protons and positrons, for instance. As regards non-electron-based charged particle microscopy, some further information can, for example, be gleaned from sources such as the following:
https://en.wikipedia.org/wiki/Focused ion beam
http://en.wikipedia.org/wiki/Scanning Helium Ion Microscope
- W.H. Escovitz, T.R. Fox and R. Levi-Setti, Scanning Transmission Ion Microscope with a Field Ion Source, Proc. Nat. Acad. Sci. USA 72(5), pp 1826-1828 (1975). http://www.ncbi.nlm.nih.gov/pubmed/22472444

It should be noted that, in addition to imaging and performing (localized) surface modification (e.g. milling, etching, deposition, etc.), a charged particle microscope may also have other functionalities, such as performing spectroscopy, examining diffractograms, etc.

In all cases, a non-transmission Charged Particle Microscope (CPM) will comprise at least the following components:
- A radiation source, such as a Schottky electron source or ion gun.
- An illuminator, which serves to manipulate a "raw" radiation beam from the source and perform upon it certain operations such as focusing, aberration mitigation, cropping (with an aperture), filtering, etc. It will generally comprise one or more (charged-particle) lenses, and may comprise other types of (particle-)optical component also. If desired, the illuminator can be provided with a deflector system that can be invoked to cause its output beam to perform a scanning motion across the specimen being investigated.
- A specimen holder, on which a specimen under investigation can be held and positioned (e.g. tilted, rotated). If desired, this holder can be moved so as to effect the desired scanning motion of the beam w.r.t. the specimen. In general, such a specimen holder will be connected to a positioning system such as a mechanical stage.
- A detector (for detecting radiation emanating from an irradiated specimen), which may be unitary or compound/distributed in nature, and which can take many different forms, depending on the radiation being detected. Examples include photodiodes, CMOS detectors, CCD detectors, photovoltaic cells, X-ray detectors (such as Silicon Drift Detectors and Si(Li) detectors), etc. In general, a CPM may comprise several different types of detector, selections of which can be invoked in different situations.
- Scanning means, for producing relative scanning motion of the irradiating beam and the specimen, thereby causing the beam to trace out a pre-determined (two-dimensional) scan pattern on (a presented surface of) the specimen. An image is then constructed on the basis of detector output per sampling point on the scan pattern, thus constructing a (two-dimensional) map of said specimen (surface). As alluded to above, such scanning means may, for example, be based on beam (scanning) deflection or holder (scanning) motion.

In what follows, the invention may - by way of example - sometimes be set forth in the specific context of electron microscopy; however, such simplification is intended solely for clarity/illustrative purposes, and should not be interpreted as limiting.

Methods as alluded to in the opening paragraph above are often performed in a SEM, for instance, in which a relatively narrow charged-particle (electron) beam (sometimes called a "probe" or primary beam) is scanned over a presented surface of the specimen, and the employed detector constructs a pixel-by-pixel image of said surface on the basis of measured electron flux as a function of coordinate position on the surface. Typically, the electron flux from the specimen can be sub-divided into different classes based on nature/energy, and can generally comprise:
- Secondary electrons (SEs): These are ejected from a k-shell of a specimen atom *via* inelastic scattering, and will typically have relatively low energies (e.g. < 50 eV). They tend to originate in a shallow region that is just below the irradiated specimen surface.
- Backscattered electrons (BSEs): These are electrons from the primary beam that are reflected / backscattered out of the (deeper-situated) specimen bulk by elastic scattering interactions with specimen atoms. They tend to have much higher energies than SEs, but can still be labelled as:
   ▪ Low-loss (single-scatter) BSEs, which escape from the specimen without undergoing further scattering, and which contain useful information regarding the specimen constitution;
   ▪ Higher-loss (multiple-scatter) BSEs, which only escape from the specimen after undergoing several scattering interactions.

As a rule of thumb:
- SE imagery is used to capture (surface) topography of a specimen;
- BSE imagery is used to capture compositional structure of the specimen.

In recent years, variants of this basic type of imaging have been developed by the present assignee. One such class of variant is, for example, set forth in United States Patents US 8,232,523 and US 8,581,189 (incorporated herein by reference), which describe a form of "computational microscopy" in which mathematical deconvolution techniques are used to reconstruct sub-surface, three-dimensional imagery. In the cited documents, this is done by (incrementally) varying a beam parameter (such as landing energy, beam current, etc.) of the irradiating beam, acquiring a "raw image" for that beam parameter, and then using these raw images as input to a reconstruction algorithm.

Although SEM imaging as set forth in the previous paragraphs has in many circumstances produced tolerable results up to now, the current inventors have worked extensively to substantially improve conventional approaches in this field. The results of this endeavor are the subject of the current invention.

It is an object of the invention to provide an improved method of examining specimens in a non-transmission CPM as referred to above. In particular, it is an object of the invention that such a method (and the associated microscope) should employ a refined detection strategy to that used in the prior art. More specifically, it is an object of the invention that the innovative method/microscope should allow crisper imagery to be obtained from certain categories of specimens, as compared to prior-art imaging of such specimens. It is a special object of the invention that said method/microscope should lend themselves to use in computational microscopy.

These and other objects are achieved in a method as set forth in the opening paragraph above, characterized in that a filter assembly is provided between said specimen and illuminator, and is used to manipulate said flux of electrons so as to:
- Preferentially pass a first category of electrons to the detector;
- Selectively impede a second category of electrons from being registered by the detector, whereby:
   - Electrons in said first category have a higher energy than electrons in said second category;
   - The filter assembly causes a deflection of electrons in said flux, which deflection is different for said first and second categories.

In experiments leading to the invention, the inventor noted that BSE imagery of biological specimens is often very sub-standard. A problem with biological specimens is that they typically have relatively poor electrical conductivity, as a result of which they tend to become electrically charged when irradiated by the primary beam in a SEM. Similar charging effects occur in the case of semi-conducting specimens, such as semiconductor substrate materials, for example. In essence, the electrostatic field associated with a charged specimen disrupts the flux of signal electrons emanating from the specimen, thereby adversely affecting imaging results. There are currently various possible ways in which one can attempt to address this problem, such as:
(i) Applying a neutralizing electrical potential to the specimen / specimen holder, or simply grounding it.
(ii) Tuning the landing energy of the primary beam to a particular value that allows a dynamic equilibrium to be reached as regards charge creation / dissipation in the specimen.
(iii) Examining the specimen in partial vacuum instead of pure vacuum.

However, these approaches create certain problems, as follows:
- A fundamental problem with approach (ii) is that, by restricting the employed landing energy value, it is completely incompatible with computational microscopy techniques that need to acquire imagery at a whole range of landing energy values.
- In a related manner, approach (iii) is also incompatible with such computational microscopy techniques, since the absorbing effect of a partially gaseous environment precludes use of landing energies below a given value, e.g. 2 keV, whereas experiments have shown that landing energies below this value (*e.g.* ca. 1.2 keV) can be important in reconstructing volume imagery for a thin region just under the specimen surface, e.g. to a depth of 10 nm.
- A problem with approach (i) is that an electrical bias on the specimen also places restrictions on the primary beam landing energies that can be employed.

It is clear that (*inter alia*) computational microscopy techniques as alluded to above require a radically different way of addressing the issue of specimen charging. In this regard, the current invention provides such a radically different solution. Of particular note is that, rather than trying to directly address the actual accumulation/presence of charge on the specimen, the current invention instead provides a way of addressing the detrimental imaging effects of such charge. More particularly, the present invention uses the insight that:
- An electrical charge on the specimen affects the mix of electrons reaching the detector. In particular, in causes a greater prevalence of relatively low-energy electrons (such as SEs and multiple-scatter BSEs) in the electron flux being monitored by the detector. These can cause significant image degradation.
- This effect can be addressed by manipulating the electron flux from the specimen, and performing preferential filtering/deflection of this flux on the basis of selectable energy categories. So, for example, the invention can be used to "weed out" lower-energy constituents (below a given threshold energy value) from the electron flux that is actually registered by the detector, thereby causing it to "see" only higher-energy electrons (above said threshold energy value, with an upper limit equal to the primary beam landing energy); an example of such a threshold value is 1.2 keV for a 2keV primary beam, for instance.
- The inventive filter assembly can achieve the required flux manipulation in different manners. For instance:
   ▪ Very-low-energy electrons (such as secondary electrons) can be repulsed / turned back by the filter assembly.
   ▪ Higher-energy electrons that (have enough inertia to) traverse the filter assembly (such as mixed single-scatter and multiple-scatter BSEs) can be steered from their default trajectory by an amount that depends on their energy. Such steering can be tuned so as to cause a first subset of these electrons to hit a (spatially confined) detection surface of the employed detector, while a second subset misses this detection surface.
- This flux manipulation mechanism places no fundamental restrictions on the employed landing energy of the primary beam. As such, the inventive method therefore lends itself to use with microscopy studies that require a range of different landing energies to be employed, as in the case of computational microscopy techniques as alluded to above, for instance.

These and other aspects of the invention will be elucidated in more detail below.

The effects described above can, for example, be achieved if the inventive filter assembly comprises an electron refractor, such as a lens or prism, for instance. In the case of a (convex) electron lens, lower-energy electrons traversing the lens will tend to be deflected more toward the optical axis of the lens than higher-energy electrons will be. Similarly, in the case of an electron prism, a "polychromatic" (multi-energy) electron flux entering the prism will undergo dispersion into separate "colors" (energies), with lower-energy electrons undergoing greater deflection/deviation than higher-energy electrons. The degree/amount of deflection exercised on an electron of a given energy can be conveniently altered by adjusting the (electrical) excitation of the refractor that it's traversing, which can be chosen to match a given threshold energy as referred to above (e.g. so as to produce a particular reference / benchmark deflection for a given electron energy).

In a particular embodiment of the present invention:
- The employed detector has an annular form, comprising a detection surface that surrounds a central aperture;
- The filter assembly directs electrons in said first category onto said detection surface, and deflects electrons in said second category away from said detection surface.

Such an arrangement lends itself particularly (but not exclusively) to a situation in which the filter assembly acts as a (circularly symmetric) lens, which can be conveniently arranged to be substantially coaxial with the detection annulus / central aperture of the detector. In such a set-up, one can choose (at least) two different operating scenarios, namely:
(a) Inward disposal: Here, lower-energy electrons can be diverted into the central aperture (where they may, for example, (ultimately) enter a beam dump), while higher-energy electrons instead intercept the annular detection surface.
(b) Outward disposal: Here, higher-energy electrons are directed onto the detection surface, whereas lower-energy electrons are diverted beyond an outer perimeter of this detection surface (where, once again, they may (ultimately) enter a beam dump, if desired).

In either case, the central aperture in the detection surface allows the detector to be located "on-axis" *vis-à-vis* the primary beam, if so desired (see next paragraph). Whether scenario (a) or (b) occurs will depend *inter alia* on the (focal) distance between the filter assembly and detector; more particularly, it will depend on whether a crossover point for a given electron (where its trajectory intersects the optical axis) lies in front of or behind the detector.

It should be noted that the annulus / central aperture referred to here do not necessarily have to be circular; for example, they could (both) be polygonal or oval in form. Moreover, the annular detection surface may, if so desired, be segmented; for example, it may be subdivided into four quadrants or six sectors, for instance. In an extrapolation of such subdivision, the detection surface could also be pixelated, for example, allowing more sophisticated spatial/energetic "sorting" of detected electrons.

In a refinement of the embodiment(s) described in the previous paragraph, the following applies:
- The filter assembly comprises a ring electrode that is connected to a power supply;
- Said ring electrode and the employed detector are substantially coaxial with an optical axis of the illuminator (the ring electrode having a reference longitudinal axis that can be defined as extending through its center and normal to its plane).

Such a ring-shaped electrode can act as lens in that, if held at a negative potential, its (net) effect on a stream of electrons passing through it will be to repulse individual electrons away from its circumference and toward its axis, whereby lower-energy electrons will be repulsed more than higher-energy electrons. An annular detector disposed on the (particle-)optical axis of the illuminator and "facing" (the plane of) the specimen can be advantageous in that it is symmetric relative to the primary beam (which can pass through its central aperture from the rear) and can therefore "see" (capture) a relatively large and symmetric distribution of emission angles of electrons emanating from the zone where the primary beam impinges on the specimen. A ring electrode co-axial with such a detector can then be conveniently used to deflect "unwanted" electrons either into the detector's central aperture (scenario (a) above) or outside its outer perimeter (scenario (b) above). A ring is essentially the simplest electrode geometry that can perform this functionality. The power supply connected to the ring should (typically) be able to hold it at a potential in a range from -100 V to -5000 V, for example. It should be noted that the term "ring" as here employed encompasses an annulus or torus, for instance.

In a particular embodiment of a scenario in which the filter assembly employs a ring-shaped electrode, said electrode is located proximal a terminal circumference of a final lens of said illuminator. For instance, it may be located just outside and/or just below said circumference, which is to be regarded as "terminal" (or extremal/ultimate) in that it pertains to a last (e.g. lowermost) lens element of the illuminator (when considered in the direction of propagation of the primary beam). In a specific example:
- The final lens element in the illuminator is magnetic in nature, with a truncated conical pole piece that tapers toward the optical axis and ends in a round surface normal to said axis.
- The ring electrode is disposed around an outer perimeter of said round surface; if desired/necessary, an electrical insulator (such as a rubber O-ring) can be disposed between the electrode and pole piece.

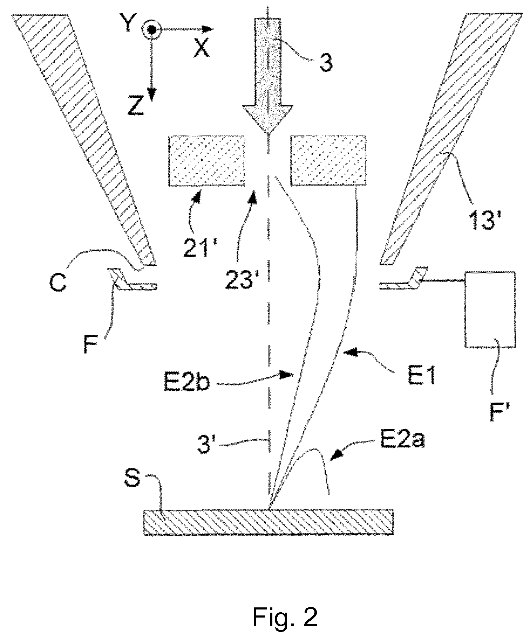

Such a situation is depicted in Figure 2, for example. It should be explicitly noted that the final lens element in the illuminator does not necessarily have to be magnetic in nature, and that the inventive filter assembly (e.g. comprising a ring-shaped electrode as set forth above) can also be used when the illuminator's final lens element is electrostatic.

As already stated above, the present invention is very compatible with imaging techniques whereby imagery is obtained for a range of different primary beam energies, e.g. as set forth in the abovementioned US 8,232,523 and US 8,581,189, which deal with a type of "SEM tomography". If, in the present invention, the primary beam energy is adjusted, then the inventive filtering assembly can be easily "co-adjusted" (e.g. by changing its excitation/potential) so as to continue to perform energy discrimination/sorting (filtering) within pre-defined parameters.

As a further advantage of the present invention, it should be noted that the inventive filter assembly can aid in deterring electrically charged particulate contamination from migrating into the illuminator from the specimen.

It should be explicitly noted that the present invention is not limited to use with biological specimens; instead, its usefulness generically extends to any type of specimen, with particular usefulness in the case of specimens in which unwanted charging effects cause image degradation.

The invention will now be elucidated in more detail on the basis of exemplary embodiments and the accompanying schematic drawings, in which:
Figure 1 renders a longitudinal cross-sectional view of an embodiment of a non-transmission CPM in which the present invention is implemented.
Figure 2 shows a detail view of part of an embodiment similar to that depicted in Figure 1 but with a somewhat different detector architecture.
Figure 3A shows a SEM image of a biological specimen made without using the current invention, whereas Figure 3B shows a corresponding image made using the present invention.

In the Figures, where pertinent, corresponding parts may be indicated using corresponding reference symbols.

### Embodiment 1

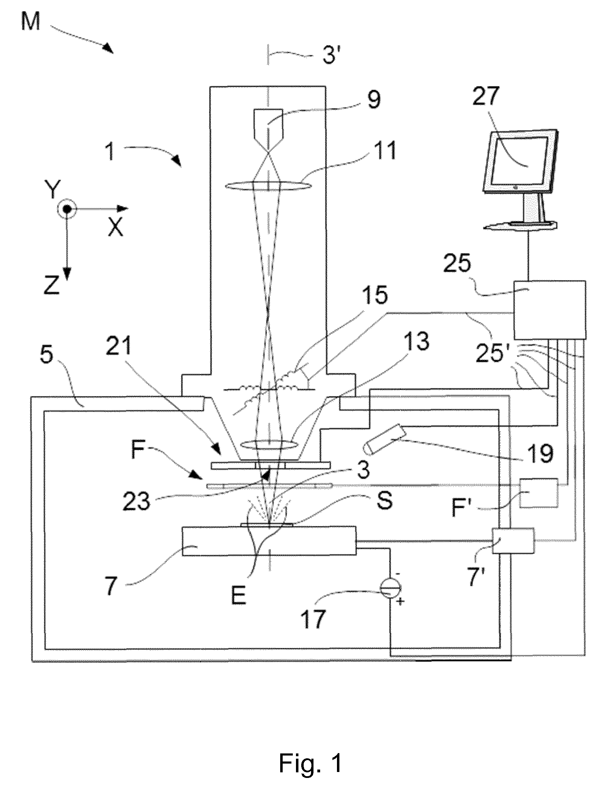

Figure 1 is a highly schematic depiction of an embodiment of a non-transmission CPM in which the present invention is implemented; more specifically, it shows an embodiment of a microscope M, which, in this case, is a SEM (though, in the context of the current invention, it could just as validly be an ion-based microscope, for example). The microscope M comprises an illuminator (particle-optical column) 1, which produces a primary beam 3 of input charged particles (in this case, an electron beam) that propagates along a particle-optical axis 3'. The illuminator 1 is mounted on a vacuum chamber 5, which comprises a specimen holder 7 and associated stage/actuator 7' for holding/positioning a specimen S. The vacuum chamber 5 is evacuated using vacuum pumps (not depicted). With the aid of voltage source 17, the specimen holder 7, or at least the specimen S, may, if desired, be biased (floated) to an electrical potential with respect to ground.

The illuminator 1 (in the present case) comprises an electron source 9 (such as a Schottky gun, for example), lenses 11, 13 to focus the electron beam 3 onto the specimen S, and a deflection unit 15 (to perform beam steering / scanning of the beam 3). The apparatus M further comprises a controller / computer processing apparatus 25 for controlling *inter alia* the deflection unit 15, lenses 11, 13 and detectors 19, 21, and displaying information gathered from the detectors 19, 21 on a display unit 27.

The detectors 19, 21 are chosen from a variety of possible detector types that can be used to examine different types of output radiation emanating from the specimen S in response to irradiation by the input beam 3. In the apparatus depicted here, the following (non-limiting) detector choices have been made:
- Detector 19 is a solid state detector (such as a photodiode) that is used to detect photoluminescence emanating from the specimen S. It could alternatively be an X-ray detector, such as Silicon Drift Detector (SDD) or Silicon Lithium (Si(Li)) detector, for example.
- Detector 21 is a segmented silicon electron detector, comprising a plurality of independent detection segments (e.g. quadrants) disposed in annular configuration about a central aperture 23 (allowing passage of the primary beam 3). Such a detector can, for example, be used to investigate the angular dependence of a flux of output backscattered electrons emerging from the specimen S. It will typically be biased to a positive potential, so as to attract electrons emitted from the specimen S.

The skilled artisan will understand that many different types of detector can be chosen in a set-up such as that depicted.

By scanning the input beam 3 over the specimen S, output radiation - comprising, for example, X-rays, infrared/visible/ultraviolet light, secondary electrons (SEs) and/or backscattered electrons (BSEs) - emanates from the specimen S. Since such output radiation is position-sensitive (due to said scanning motion), the information obtained from the detectors 19, 21 will also be position-dependent. This fact allows (for instance) the output of detector 21 to be used to produce a BSE image of (part of) the specimen S, which image is basically a map of an output of detector 21 as a function of scan-path position on the specimen S.

The signals from the detectors 19, 21 pass along control lines (buses) 25', are processed by the controller 25, and displayed on display unit 27. Such processing may include operations such as combining, integrating, subtracting, false colouring, edge enhancing, and other processing known to the skilled artisan. In addition, automated recognition processes (e.g. as used for particle analysis) may be included in such processing.

It should be noted that many refinements and alternatives of such a set-up will be known to the skilled artisan, including, but not limited to:
- The use of dual beams - for example an electron beam 3 for imaging and an ion beam for machining (or, in some cases, imaging) the specimen S;
- The use of a controlled environment at the specimen S - for example, maintaining a pressure of several mbar (as used in a so-called Environmental SEM) or by admitting gases, such as etching or precursor gases,
*etc.*

In the specific context of the current invention, attention is drawn to the following. Between the specimen S and illuminator 3, a filter assembly F has been provided, which is connected to a (high-voltage) power supply F'. When activated with a suitable electrical potential from power supply F', filter assembly F can be used to manipulate a flux E of electrons emanating from the specimen S in response to irradiation with the primary beam 3, whereby:
- A first category of electrons in flux E (with an energy above a given threshold value) are allowed to pass to detector 21;
- A second category of electrons in flux E (with an energy below a given threshold value) are impeded from reaching the annular detection surface of detector 21.

To produce such manipulation of the flux E, the filter assembly F cause electrons in flux E to divert (deflect) from their default paths, in a way that is dependent on the energy of the electrons in question. So, for example:
- Relatively low-energy electrons in flux E (such as multiple-scatter BSEs) can be steered by filter assembly F into the central opening 23 of detector 21.
- Relatively high-energy electrons in flux E (such as single-scatter BSEs) can be steered by filter assembly F into the detection annulus of detector 21.
- Very-low-energy components of flux E - such as SEs - may be repulsed by filter assembly F and directed back toward the specimen S.
These aspects of the invention are discussed in more detail in the next Embodiment.

### Embodiment 2

Figure 2 shows a detail view of part of an embodiment similar to that depicted in Figure 1 but with a somewhat different detector architecture. More specifically, whereas the (annular) electron detector 21 of Figure 1 is located below the last lens element 13, the (annular) electron detector 21'of the present embodiment is nested within this last lens element, which is here embodied as a magnetic lens with an associated pole piece 13'. These particular design choices are voluntary, and are in no way binding as regards the essence of the present invention's operation.

Clearly visible in Figure 2 is the inventive filter assembly F, which is here embodied as a ring-shaped electrode that is substantially centered on particle-optical axis 3' (just as detector 21' is). This ring F is located proximal to a terminal circumference C of pole piece 13' - in this case just outside and below C - and is electrically insulated from pole piece 13' by an intervening vacuum gap and/or (un-depicted) insulator ring. The detector 21' can, for example, be biased to a positive potential of the order of ca. 7000 V, and the depicted set-up may, for instance, have the following (non-limiting, approximate) dimensioning:
- Diameter of terminal circumference C: 10 mm
- Outer diameter of ring F: 20 mm
- Inner diameter of ring F: 10 mm
- Thickness of ring F (in Z-direction): 0.2 mm
- Separation (in Z) of ring F and pole piece 13': 0.5 mm
- Separation (in Z) of ring F and specimen S: 7 mm
- Separation (in Z) of detector 21' and specimen S: 15 mm
- Outer diameter of annular detector 21': 10 mm
- Diameter of central aperture 23': 2.5 mm

The ring F may, for example, be made of a material such as titanium or stainless steel, and is connected to a (high-voltage) power supply F', which, in the current case, is used to apply an adjustable negative potential to ring F, e.g. in the range 0 to - 5000V volts. This negative potential causes electrons that traverse the ring F to be diverted laterally from the course that they would otherwise follow in the absence of ring F, whereby:
- Deflection occurs inward, toward axis 3';
- The magnitude of the deflection is energy-dependent, being greater for lower-energy electrons than for higher-energy electrons.

The Figure shows the effect of such a (suitably selected) potential on two different categories of electron in flux E, whereby:
- In a first category: Electron E1 is a relatively high-energy electron, such as a single-scatter (low-loss) BSE, with an energy in the (decreasing) range E_{I} to E_{T}, where E_{I} is the landing energy (incident energy) of beam 3 and E_{T} is a selected threshold energy. The potential on ring F can be selected so that electron E1 (and others of similar energy) is steered onto (some part of) the annular detection surface 21'. In a typical (non-limiting) example, E_{I} can have a value in the range 500-5000 eV, and E_{T} can have a value in the range 250-3000 eV, for instance.
- In a second category: Electrons E2a and E2b are impeded by (the potential on) ring F from landing on detection surface 21'. Electrons in this category have energy ≤ E_{T}. These electrons are of two different types, namely:
   ▪ A secondary electron (SE) E2a, with an energy in the range 0-50 eV, for example. This is repulsed backward by ring F, and deflected back down toward specimen S;
   ▪ A multiple-scatter BSE E2b, which (because of its greater energy than SE E2a) reaches and traverses the ring F. Because it has less energy than E1, it suffers greater deflection by ring F, and is here steered into central aperture 23' rather than onto annular detection surface 21'.

In this way, the inventive filter assembly efficiently "weeds out" lower-energy electrons in the second category, and prevents them from being "seen" by detector 21'.

### Embodiment 3

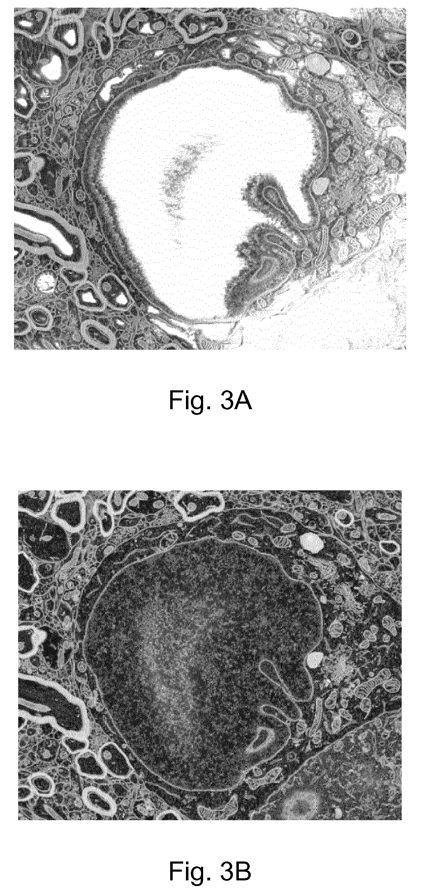

To illustrate the effect of the present invention, SEM images were made of a biological specimen (a nucleus of a rat brain cell), and these are shown in Figure 3, whereby:
- Figure 3A shows an image obtained without application of the current invention (prior art);
- Figure 3B shows corresponding imagery made using the present invention.
Note that:
- It is immediately apparent that large areas of Figure 3A suffer from a whitish "glare" in which essentially no detail is visible. This is particularly the case for the central and lower right regions of the image. The effect is attributed to electrostatic charging of the specimen in question.
- In Figure 3B, this "glare" is absent, and crisp detail is visible that is not visible in Figure 3A. This huge improvement in image quality is achieved by using the present invention to "weed out" lower-energy electrons from the image.

In both images, the magnification is 8700x, and the primary beam energy is 1780 V. In the imagery of Figure 3B, the selected value of E_{T} was 900 eV.

## Claims

1. A method of examining a specimen in a non-transmission Charged Particle Microscope, comprising the following steps:
- Providing a specimen on a specimen holder;
- Directing an irradiating beam of charged particles from a source through an illuminator so as to irradiate the specimen;
- Causing relative motion of the beam relative to the specimen, so as to trace out a scan path;
- Using a detector to detect a flux of electrons emanating from the specimen in response to said irradiation,
**characterized in that** a filter assembly is provided between said specimen and illuminator, and is used to manipulate said flux of electrons so as to:
- Preferentially pass a first category of electrons to the detector;
- Selectively impede a second category of electrons from being registered by the detector, whereby:
- Electrons in said first category have a higher energy than electrons in said second category;
- The filter assembly causes a deflection of electrons in said flux, which deflection is different for said first and second categories.

2. A method according to claim 1, wherein:
- Said first category comprises backscattered electrons with an energy value between a landing energy of said irradiating beam and a given threshold energy;
- Said second category comprises electrons with an energy value below said threshold energy.

3. A method according to claim 1 or 2, wherein said filter assembly comprises an electron refractor.

4. A method according to any of claims 1-3, wherein:
- Said detector has an annular form, comprising a detection surface that surrounds a central aperture;
- The filter assembly directs electrons in said first category onto said detection surface, and deflects electrons in said second category away from said detection surface.

5. A method according to claim 4 when dependent on claim 3, wherein:
- Said filter assembly comprises a ring electrode that is connected to a power supply;
- Said ring electrode and detector are substantially coaxial with an optical axis of said illuminator.

6. A method according to claim 5, wherein said ring electrode is located proximal to a terminal circumference of a final lens of said illuminator.

7. A method according to any of claims 1-6, wherein said filter assembly is used to mitigate image-deterioration effects of specimen charging.

8. A method according to claim 7, wherein said specimen is selected from the group comprising electrically non-conducting and semi-conducting specimens.

9. A method according to any of claims 1-8, wherein, in each of a sequence of imaging sessions, the irradiating beam is adjusted to have a different energy.

10. A non-transmission Charged Particle Microscope, comprising:
- A specimen holder, for holding a specimen;
- A source, for producing an irradiating beam of charged particles;
- An illuminator, for directing said beam so as to irradiate the specimen;
- Scanning means, for causing relative motion of the beam relative to the specimen, so as to trace out a scan path;
- A detector, for detecting a flux of electrons emanating from the specimen in response to said irradiation,
**characterized by** a filter assembly that is provided between said specimen holder and illuminator and is adjustable to manipulate said flux of electrons so as to:
- Preferentially pass a first category of electrons to the detector;
- Selectively impede a second category of electrons from being registered by the detector, whereby:
- Electrons in said first category have a higher energy than electrons in said second category;
- The filter assembly is configured to cause a deflection of electrons in said flux, which deflection is different for said first and second categories.
